# EUROPEAN PATENT APPLICATION

(11) **EP 1 947 687 A2**
(43) Date of publication of application: **23.07.2008**
(21) Application number: 07119077.1
(22) Date of filing: 23.10.2007
(51) Int. Cl.: H01L 21/60, G06K 19/077

(54) **Method and apparatus for manufacturing electronic device**

(30) Priority: 18.01.2007 JP 2007009262
(71) Applicant: Fujitsu Ltd., Kawasaki-shi, Kanagawa 211-8588 (JP)
(72) Inventor: Kobayashi, Hiroshi, Kawasaki-shi, Kanagawa 211-8588 (JP)
(74) Representative: Wilding, Frances Ward

(57) **Abstract**

A method of manufacturing an electronic device includes the steps of: attaching a thermoset adhesive to a surface of a base obtained by forming a conductor pattern on a film made of a resin material, the conductor pattern being formed on the surface of the base; mounting a circuit chip on the base via the thermoset adhesive such that the chip is connected to the conductor pattern; holding the base by a heater for heating the thermoset adhesive including a holding section and a supporting section such that the holding section abuts against the circuit chip and the supporting section abuts against the film, and causing the film to be adhered to the supporting section; and heating and hardening the thermoset adhesive by the heater and thereby fixing the circuit chip to the conductor pattern.

## Description

### BACKGROUND OF THE INVENTION

### Field of the Invention

The present invention relates to a method and an apparatus for manufacturing an electronic device, and particularly relates to a method and an apparatus for manufacturing an electronic device in which a circuit chip is mounted on a film-like base.

### Description of the Related Art

Conventionally, there has been widely known an electronic device in which a circuit chip is mounted on a base such as a printed circuit board. Such an electronic device is built in an electronic equipment to control the electronic equipment, or used alone to exchange information with external equipment. Such an electronic device includes Radio Frequency Identification (RFID) tags of various kinds that wirelessly exchange information in a non-contact manner with an external device typified by a reader/writer. One type of RFID tag that has been proposed has a structure in which a conductor pattern for radio communication and an IC chip are mounted on a sheet-like base. Applications of such an RFID tag include identification of an article by attaching the RFID tag to the article and thereby exchanging information about the article with external equipment.

Incidentally, there is the demand for a more compact and lighter RFID. Specifically, a thinner and more flexible RFIDwith decreased cost is demanded. In response to such a demand, there has been proposed a RFID tag in which a film formed of a resin material such as polyethylene terephthalate (PET) is used as a base on which an IC chip is mounted (for example, see Japanese Patent Application Laid-Open No. 2001-156110).

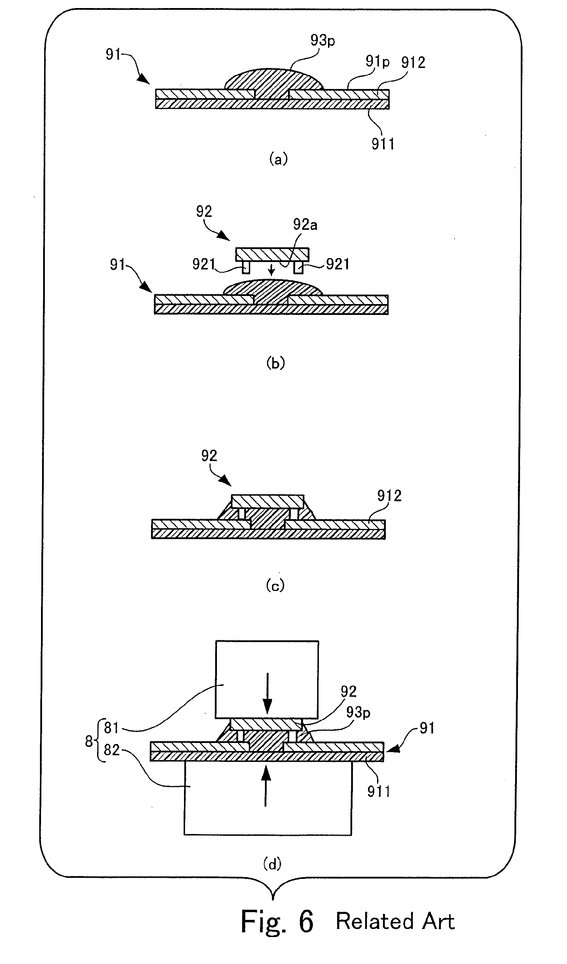

Fig. 6 is a diagram showing a conventional method of manufacturing a RFID tag.

Parts (a)-(d) of Fig. 6 sequentially shows processes for manufacturing a RFID tag.

In order to manufacture a RFID tag, as shown in part(a) of Fig. 6, a base 91 is prepared by forming a conductor pattern 912 that serves as an antenna of a RFID tag on a film 911 formed of PET. Subsequently, a thermoset adhesive 93p that hardens by heat is attached onto the base 91.

Next, as shown in part (b) of Fig. 6, an IC chip 92 is mounted on the base 91 at a portion where the thermoset adhesive 93p is attached. The IC chip 92 has bumps 921 that are connected with the conductor pattern 912. Therefore, as shown in part (c) of Fig. 6, the IC chip is mounted on the base 91 such that the bumps 921 are aligned with the conductor pattern 912.

Then, as shown in part (d) of Fig. 6, the base 91 mounted with the IC chip 92 is held by a heater 8. Subsequently, a heating head 81 of the heater 8 that contacts the IC chip 92 heats and hardens the thermoset adhesive 93p. Accordingly, the IC chip 92 is fixed to the base 91 such that the bumps 921 is in contact with the conductor pattern 912, which completes a small and light RFID tag.

However, PET material that forms the film 911 is low in heat resistance as it has the glass transition temperature of about 67°C. Therefore, the film 911 is likely to deform when the thermoset adhesive 93p is heated and hardened.

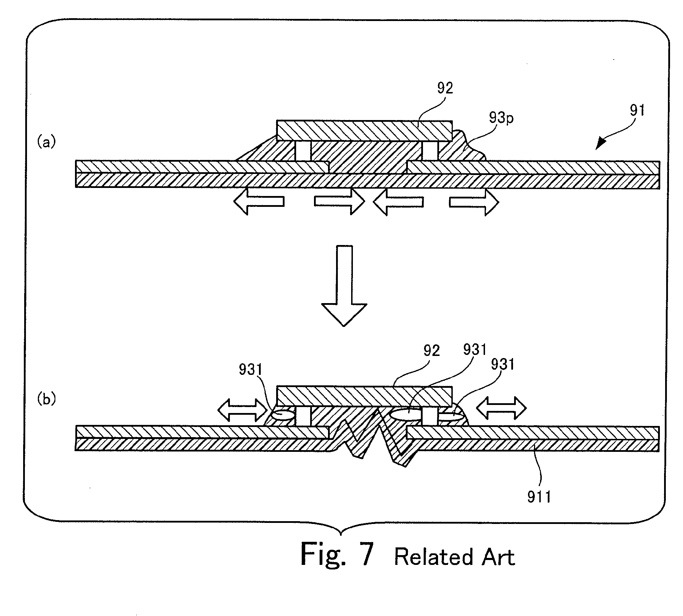

Fig. 7 is a diagram for illustrating a state of the base 91 when heated in the heating process shown in part (d) of Fig. 6.

As shown in part (a) of Fig. 7, when the base 91 mounted with the IC chip 92 is heated, temperature of the base 91 rises, resulting in deformation of the film 911. As the film 911 is deformed, the thermoset adhesive 93p is caused to flow, resulting in generation of air bubbles in the thermoset adhesive 93p. The air bubbles remain as voids 931 in the thermoset adhesive 93p even after it is hardened, which decreases adhesive strength between the base 91 and the IC chip 92 and thus leads to degraded reliability of a RFID tag.

Such a problem of degraded reliability due to generation of voids also arises, other than a RFID tag, in any electronic device in which a circuit chip is mounted on a film-like base.

### SUMMARY OF THE INVENTION

Embodiments of the present invention have been made in view of the above circumstances and may provide a method and an apparatus for manufacturing an electronic device that enhances reliability of the electronic device by suppressing generation of voids.

According to an embodiment of a first aspect of the present invention, there is provided a method of manufacturing an electronic device, including the steps of:
attaching a thermoset adhesive to one surface of a base obtained by forming a conductor pattern on a film made of a resin material, the conductor pattern being formed on the one surface;
mounting a circuit chip on the base via the thermoset adhesive such that the chip is connected to the conductor pattern;
holding the base by a heater for heating the thermoset adhesive including a holding section and a supporting section such that the holding section abuts against the circuit chip and the supporting section abuts against the film, and causing the film to be adhered to the supporting section; and
heating and hardening the thermoset adhesive by the heater and thereby fixing the circuit chip to the conductor pattern.

According to the present aspect, when the base is held by the holding section and the supporting section of the heater, the film of the base may be adhered to the supporting section. This may prevent deformation of the film even when it melts due to heat. As generation of voids in the thermoset adhesive when heated may be suppressed, reliability of the electronic device may be upgraded. In addition, the resultant enhanced yield rate may lead to reduction in manufacturing costs.

Here, in a method of manufacturing the electronic device embodying to the present aspect, preferably the holding of the base may be a step of adhering the film to an adhering member in a form of a layer by interposing the adhering member between the supporting section and the film.

Examples of "interposing" a layer of the adhering member between the supporting section and the filmmay include forming the adhering member on a surface of the supporting section, or on a surface of the film, or on a sheet separate from the supporting section and film such that the sheet may be held between the supporting section and film.

The interposed adhesive member between the supporting section and film may make the film adhered to the supporting section only by holding the base mounted with the circuit chip such that the base may be held between the supporting section and holding section. This simple structure may prevent generation of voids due to a deformed film.

More preferably, the supporting section may be provided with an adhesive layer formed on a surface of the supporting section which surface abuts against the film.

The adhesive layer formed on the supporting section may eliminate the need to form an adhesive layer for each of electronic devicees to be manufactured.

Additionally, in a method of manufacturing the electronic device embodying to the present aspect, the supporting section may have an adsorption mechanism of adsorbing the film, and the heating and hardening of the thermoset adhesive may be a step of adsorbing the film by the supporting section.

Such an adsorption mechanism may allow adjustment of adhesion strength of the film to the supporting section independently of the force by which the base is held by the supporting section and the holding section. Thus, both forces may be adjusted separately and optimally according to their circumstances.

Alternatively, in a method of manufacturing the electronic device embodying the present aspect, the supporting section may have multiple small openings formed on a surface of the supporting section which surface abuts against the film, and the heating and hardening of the thermoset adhesive may be a step of causing the supporting section to adsorb the film to the supporting section by sucking air through inside the micro pores.

As the small openings formed widely on the surface of the supporting section may cause the supporting section to adsorb the film, it may be possible to prevent a case in which the film is caught in a larger opening and deformed. Additionally, it may enable uniform adhesion of the film to the wide area of the supporting section.

According to an embodiment of a second aspect of the present invention, there is provided an apparatus for manufacturing an electronic device having a base which is obtained by forming a conductor pattern on a surface of a film made of a resin material and a circuit chip fixed to the conductor pattern via a thermoset adhesive. The apparatus includes:
a holding section that holds the base by abutting against the circuit chip that is mounted on one surface of the base via the thermoset adhesive, the conductor pattern being formed on the one surface;
a supporting section that supports the base by abutting against the film of the base, thereby adhering the film to the supporting section; and
a heating section that hardens the thermoset adhesive by heat, thereby fixing the circuit chip to the conductor pattern.

According to such an apparatus for manufacturing the electronic device, when the thermoset adhesive is heated, the base may be held between the holding section and the supporting section so that the film of the base may be adhered to the supporting section. Thus, it may be possible to suppress generation of voids in the thermoset adhesive due to deformation of the film.

As mentioned above, embodiments of the present invention realize a method and an apparatus for manufacturing an electronic device that may enhance reliability of the electronic device by suppressing generation of voids.

### BRIEF DESCRIPTION OF THE DRAWINGS

Fig. 1 is a perspective view of a RFID tag that is to be manufactured by a first embodiment according to the present invention;
Fig. 2 is a view for illustrating a method of manufacturing the RFID tag shown in Fig. 1, according to the first embodiment of the present invention;
Fig. 3 is a perspective view that schematically illustrates a structure of a heater;
Fig. 4 is a perspective view for schematically illustrating a structure of a heater that is used in a manufacturing method according to a second embodiment of the present invention;
Fig. 5 is a sectional view for schematically illustrating an internal structure of a heating stage in adhesion process according to the second embodiment of the present invention;
Fig. 6 is a diagram showing a conventional method of manufacturing an RFID tag; and
Fig. 7 is a diagram for illustrating a state of a base in a heating process of Fig. 6.

### DETAILED DESCRIPTION OF THE INVENTION

Embodiments of the present invention will be described below with reference to the drawings.

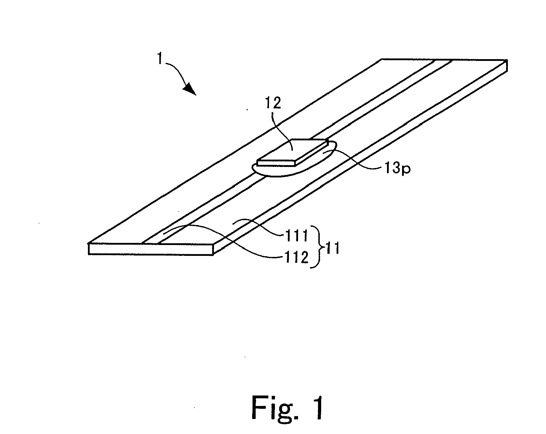

Fig. 1 is a perspective view of a RFID tag that is to be manufactured by a first embodiment of the present invention.

A RFID tag 1 includes a base 11 prepared by forming a metal antenna pattern 112 on a film 111 made of a PET material; an IC chip 12 mounted on the base 11; and a thermoset adhesive 13p for adhering the IC chip 12 to the base 11.

The RFID tag 1 of the present invention is an electronic device for exchanging information in a non-contact manner with a reader/writer (not shown). More specifically, the RFID tag 1 receives electromagnetic field energy from the reader/writer by the antenna pattern 112 as electric energy which in turn drives the IC chip 12. The antenna pattern 112 serves as a communication antenna and the IC chip 12 performs radio communication via the antenna pattern 11.

Here, the RFID tag 1 corresponds to an example of the electronic device according to the present invention; the antenna pattern 112 corresponds to an example of the conductor pattern according to the present invention; and the IC chip 12 corresponds to an example of the circuit chip according to the present invention.

Incidentally, the "RFID tag" employed in the present invention may be called as a "RFID tag inlay" by those skilled in the art, as the "RFID tag" of the present invention corresponds to an inner component for a RFID tag. Alternatively, the "RFID tag" of the present invention may be called as a "wireless IC tag, " and includes a non-contact IC card.

Hereafter, the method of manufacturing the RFID tag 1 will be described.

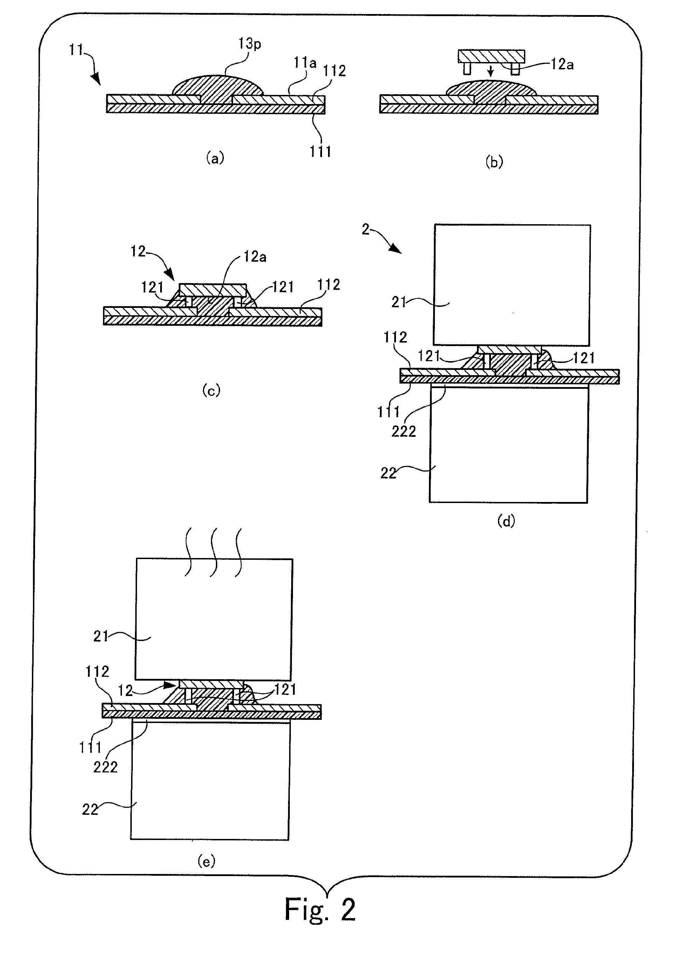

Fig. 2 is a view that illustrates a method of manufacturing the RFID tag 1 shown in Fig. 1 according to the first embodiment of the present invention.

In parts (a)-(d) of Fig. 2, manufacturing processes of the RFID tag 1 are sequentially shown. In order to make it easy to see, dimensions of the thickness of the RFID tag 1 and the IC chip 12 are emphasized (enlarged) relative to those shown in Fig. 1.

In manufacturing the RFID tag 1, as shown in part (a) of Fig. 2 that is an attachment process, the base 11 is prepared by forming the antenna pattern 112 on the film 111 and attaching the thermoset adhesive 13p in a formof liquid or sheet to the base 11. Specifically, the thermoset adhesive 13p is applied to an area and its periphery where the IC chip 12 is mounted on a surface of the base 11 in which the antenna pattern is formed.

In mounting process shown in parts (b) and (c) of Fig. 2 after the attachment process, the IC chip 12 is mounted on the area of the base 11 where the thermoset adhesive 13p is applied using the flip chip method. Specifically, the IC chip 12 is mounted on the base 11 with the thermoset adhesive 13p interposed therebetween so that a surface 12a of the IC chip 12, in which a circuit is formed, faces the base 11. Bumps 121 to be connected to the antenna pattern 112 are disposed on the surface 12a of the IC chip 12 where a circuit is formed. As shown in part (c) of Fig. 2, the IC chip 12 is mounted on the base 11 such that the bumps 121 are aligned with the antenna pattern 112.

Subsequently, in adhesion process shown in part (d) of Fig. 2, a heater 2 holds the base 11 mounted with the IC chip 12 such that the heater 2 abuts against both the film 111 and the IC chip 12. The heater 2 includes a heating head 21 with a built-in heater (not shown) and a heating stage 22 which hold the base 11 therebetween. In the adhesion process, the heating head 21 and heating stage 22 respectively abut against the IC chip 12 and the film 111. The heater 2 is an example of the apparatus for manufacturing the electronic device according to the present invention; the heating head 21 is an example corresponding to combination of the holding section and the heating section according to the present invention; and the heating stage 22 is an example of the supporting section according to the present invention.

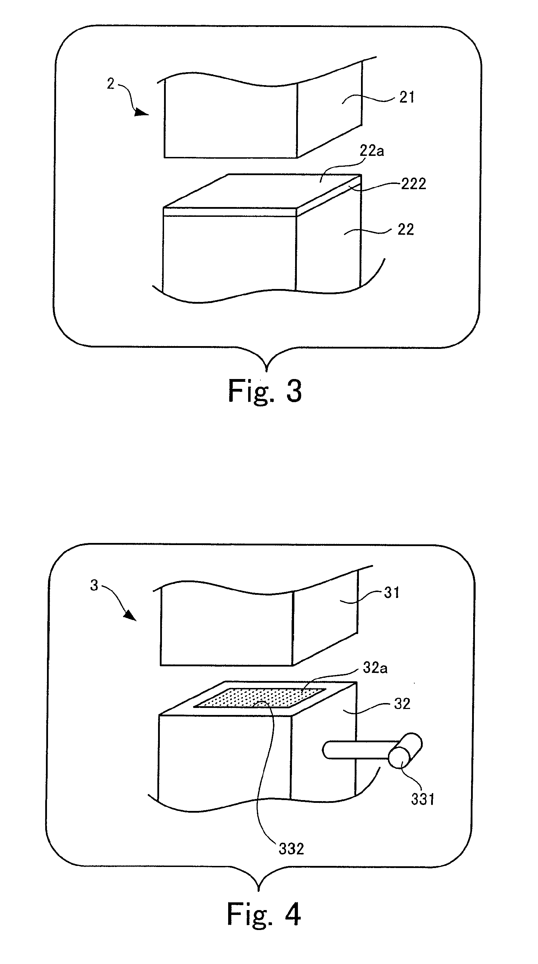

Fig. 3 is a perspective view for schematically illustrating the structure of the heater 2.

As shown in Fig. 3, the heating stage 22 of the heater 2 has an adhesive layer 222 formed on a surface 22a that is to abut against the film 111. The adhesive layer 222 is made of a resin material having weak adhesiveness that allows the film 111 to be adhered to and detached from the adhesive layer 222 after completion of a RFID tag without damaging the adhesive layer 222. For example, Japanese Patent Application Laid-Open No. 2004-158477 describes fluorine resin having adhesiveness of 10 g/cm2 or more and 2000g/cm2 or less. The adhesive layer 222 of the present embodiment is made of such a fluorine resin. However, other material such as silicone resin may be employed as far as it allows the film 111 to be adhered to and detached from the adhesive layer 222 without damaging adhesive layer 222. The adhesive layer 222 is an example of the adhesive layer and the adhesive member according to the present invention.

Referring back to Fig. 2, in adhesion process shown in part (d) of Fig. 2, the base 11 mounted with the IC chip 12 is sandwiched between the heating head 21 and the heating stage 22 having the adhesive layer 222 formed thereon. Thus, the film 111 is adhered to the heating stage 22 via the adhesive layer 222 while the bumps 121 are securely in contact with the antenna pattern 112.

Subsequently, in heating process shown in part (e) of Fig. 2, the heating head 21 is caused to heat and harden the thermoset adhesive 13p. The hardened adhesive 13p makes the bumps 121 of the IC chip 12 fixed to the base 11 such that the bumps 121 are in contact with the antenna pattern 112. This heating process prevents the film 111 from being deformed even when the film 111 melts due to heat because in the heating process the film is adhered to the heating stage 22. Therefore, it is possible to suppress generation of voids accompanying deformation of the film 111.

The end of the heating process in part (e) of Fig. 2 completes the RFID tag 1 shown in Fig. 1.

From now on, a second embodiment of the present invention will be described. In the second embodiment, a structure of a heating stage is different from that of the first embodiment of the present invention, and the descriptions below will focus on that difference, using the same reference characters for the components in common with the first embodiment.

Fig. 4 is a perspective view for schematically illustrating a structure of a heater that is used in a second embodiment of the present invention.

A heater 3 shown in Fig. 4 includes a heating head 31 and a heating stage 32. The heating stage 32 has, instead of the adhesive layer 222, multiple small openings 333 formed on a surface 32a that abuts against the film 111. The heating stage 32 also has a vacuum pump 331 that adsorbs the film 111. The small openings 333 and the vacuumpump 331 provided in the heating stage 32 are the components different from the first embodiment. The vacuum pump 331 causes the surface 32a of the heating stage 32 to adsorb the film 111 by sucking air through the small openings 333.

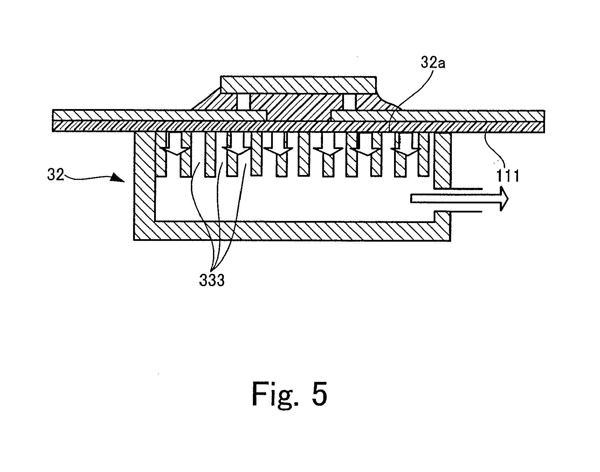

Fig. 5 is a sectional view of schematically illustrating an internal structure of the heating stage 32 in adherence process according to the second embodiment of the present invention.

As shown in Fig. 5, the small openings 333 are formed on the surface 32a of the heating stage 32 that is to abut against the film 111 and are linked through the inside of the heating stage 32 to the vacuum pump 331 (see Fig. 4). In adhesion process of the second embodiment, the vacuum pump 331 causes the surface 32a of the heating stage 32 to adsorb the film 111 by sucking air through the small openings 333. The vacuum pump 331 adjusts an adhesion strength with which the film is adhered to the heating stage 32 and a timing for adhesion and releasing adhesion. This adjustment is conducted independently of a force by which the base 11 is held by the heating stage 32 and heating head 31 (see Fig. 2) . Further, as the multiple small openings 333 are formed widely over the surface 32a of the heating stage 32, it is possible to prevent deformation of the film 111 and thus realize uniform adhesion of the film 111 to the heating stage 32.

In the first and second embodiments of the present invention, descriptions are made on the method of manufacturing the RFID 1 tag and the heaters 2, 3. However, the present invention is not limited to a RFID tag and may be also applied to a method of manufacturing any other electronic device in which a circuit chip is mounted on a film-like base. For example, the present invention may be employed to a manufacturing method of an ultrathin IC card, or a printed circuit board in which a circuit chip is fixed to a flexible printed circuit (FPC) as a base with a thermoset adhesive.

Also in the first embodiment, the heating stage 22 provided with the adhesive layer 222 has been described. However, according to the present invention, an adhesive layer with an adhesive member may be formed on the film 111.

Additionally, in the descriptions of the embodiments according to the present invention, the film 111 as a component of the base 11 of the RFID tag 1 is made of PET material. However, the film according to the present inventionmaybe formed of a material selected from among polyester, polyolefin, polycarbonate and acryl.

Also in the descriptions of the embodiments, the heating heads 21 and 31 serve as the holding section as well as heating section, and the heating stage does not have a heating function. However, according to the present invention, the supporting section may be combined with the heating section, or, the heating section may be provided separately from the holding section and supporting section.

## Claims

1. A method of manufacturing an electronic device comprising the steps of:
attaching a thermoset adhesive to one surface of a base obtained by forming a conductor pattern on a film made of a resin material, the conductor pattern being formed on the one surface;
mounting a circuit chip on the base via the thermoset adhesive such that the chip is connected to the conductor pattern;
holding the base by a heater for heating the thermoset adhesive including a holding section and a supporting section such that the holding section abuts against the circuit chip and the supporting section abuts against the film, and causing the film to be adhered to the supporting section; and
heating and hardening the thermoset adhesive by the heater and thereby fixing the circuit chip to the conductor pattern.

2. The method according to claim 1, wherein the holding of the base is a step of adhering the film to an adhering member in a form of a layer by interposing the adhering member between the supporting section and the film.

3. The method according to claim 1 or 2, wherein the supporting section is provided with an adhesive layer formed on a surface of the supporting section which surface abuts against the film.

4. The method according to claim 3, wherein the adhesive layer is made of a resin material having weak adhesiveness that allows the film to be adhered to and detached from the adhesive layer without damaging the adhesive layer.

5. The method according to any preceding claim, wherein the supporting section has an adsorption mechanism of adsorbing the film, and
the heating and hardening of the thermoset adhesive is a step of adsorbing the film by the supporting section.

6. The method according to any preceding claim, wherein the supporting section has multiple small openings formed on a surface of the supporting section which surface abuts against the film, and
the heating and hardening of the thermoset adhesive is a step of causing the supporting section to adsorb the filmto the supporting section by sucking air through the small openings.

7. The method according to any preceding claim, wherein the electronic device is a RFID tag that causes the conductor pattern to function as a communication antenna and performs radio communication via the conductor pattern using the circuit chip.

8. An apparatus for manufacturing an electronic device having a base which is obtained by forming a conductor pattern on a surface of a film made of a resin material and a circuit chip fixed to the conductor pattern via a thermoset adhesive, the apparatus comprising:
a holding section that holds the base by abutting against the circuit chip that is mounted on one surface of the base via the thermoset adhesive, the conductor pattern being formed on the one surface;
a supporting section that supports the base by abutting against the film of the base, thereby adhering the film to the supporting section; and
a heating section that hardens the thermoset adhesive by heat, thereby fixing the circuit chip to the conductor pattern.

9. The apparatus according to claim 8, wherein the supporting section is provided with an adhesive layer capable of being adhered to the film, on a surface of the supporting section which surface abuts the film.

10. The apparatus according to claim 9, wherein the adhesive layer is made of a resin material having weak adhesiveness that allows the film to be adhered to and detached from the adhesive layer without damaging the adhesive layer.

11. The apparatus according to any of claims 8 to 10, wherein the supporting section has an adsorption mechanism of adsorbing the film.

12. The apparatus according to any of claims 8 to 11, wherein the supporting section has multiple small openings that are formed on a surface abutting against the film and that cause the film to be adsorbed to the supporting section by sucking air through the small openings.
